(19) **Europäisches Patentamt**

**European Patent Office**

**Office européen des brevets**

(11) **EP 1 196 926 B1**

(12) **FASCICULE DE BREVET EUROPEEN**

(45) Date de publication et mention
de la délivrance du brevet:
**16.03.2005 Bulletin 2005/11**

(21) Numéro de dépôt: **00946012.2**

(22) Date de dépôt: **26.06.2000**

(51) Int Cl.⁷: $G11C\ 16/12$, $G11C\ 16/30$

(86) Numéro de dépôt international:
**PCT/FR2000/001776**

(87) Numéro de publication internationale:
**WO 2001/003141 (11.01.2001 Gazette 2001/02)**

(54) **CIRCUIT DE PRODUCTION DE TENSION**

SPANNUNGSERZEUGUNGSSCHALTUNG FÜR SMART CARD

VOLTAGE PRODUCTION CIRCUIT

(84) Etats contractants désignés:
**DE FR GB IT**

(30) Priorité: **30.06.1999 FR 9908663**

(43) Date de publication de la demande:
**17.04.2002 Bulletin 2002/16**

(73) Titulaire: **STMicroelectronics S.A.**
**92120 Montrouge (FR)**

(72) Inventeurs:
• **DEVIN, Jean**
**F-13100 Le Tholonet (FR)**
• **CHEHADI, Mohamad**
**13090 Aix-en-Provence (FR)**

(74) Mandataire: **Bentz, Jean-Paul et al**
**Cabinet Ballot**
**9, rue Claude Chappe**
**Metz Technopôle**
**57070 Metz (FR)**

(56) Documents cités:
**EP-A- 0 917 684**      **US-A- 5 285 370**
**US-A- 5 572 478**

## Description

L'invention a pour objet un circuit de production d'une haute tension. L'invention est plus particulièrement applicable à des cartes à puces sans contact comprenant une mémoire programmable et effaçable électriquement.

I1 est connu, notamment du document D1 (EP 0 917 684), d'utiliser, dans une carte à puce sans contact, un circuit comprenant des moyens pour détecter un signal radio fréquence et produire une basse tension d'alimentation à partir du signal radio fréquence. I1 n'est cependant pas prévu dans D1 de produire une haute tension différente de la basse tension d'alimentation.

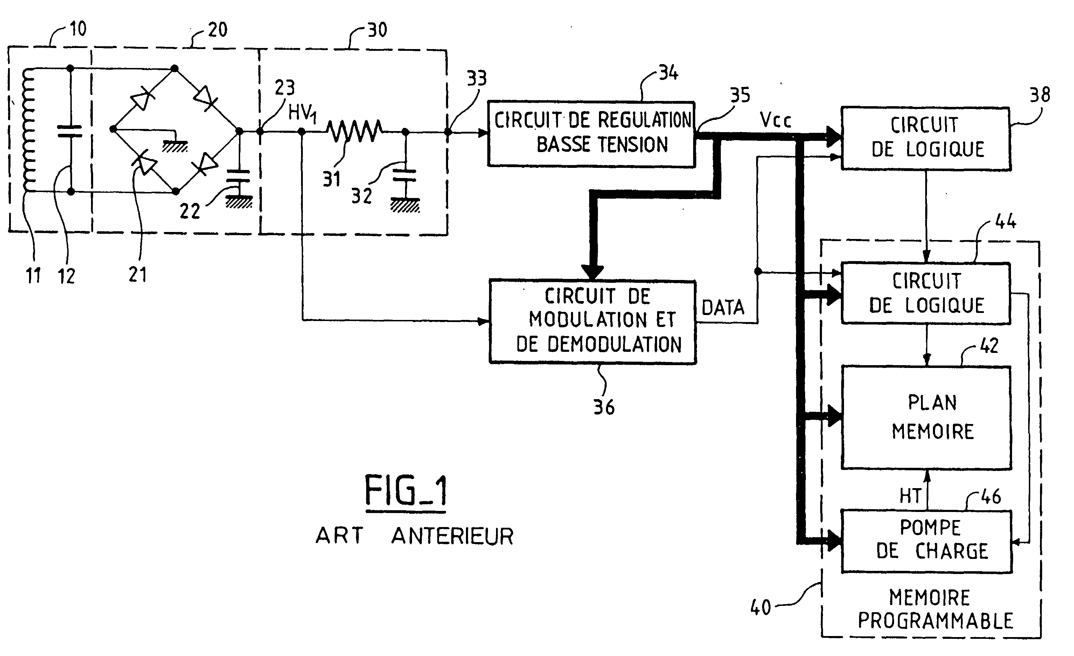

La figure 1 présente un schéma également connu d'un circuit intégré pour carte à puce sans contact, qui comprend un circuit de détection 10, un circuit de redressement 20, un filtre 30, un circuit de régulation basse tension 34, un circuit de modulation et de démodulation 36, un circuit de logique 38, et une mémoire 40.

Le circuit de détection 10 comprend un circuit résonant constitué d'une boucle d'antenne représentée par les spires d'un bobinage 11 et d'un condensateur 12 en parallèle. Le circuit de redressement 20 comprend un pont à quatre diodes 21 et un condensateur 22 dont l'une des bornes est reliée à la masse.

Le filtre 30 comprend une résistance 31 et un condensateur 32. Une des bornes de la résistance 31 est connectée au point commun 23 d'une des sorties du pont de diodes 21 et du condensateur 22. Une autre borne de la résistance 31 est connectée à une des bornes du condensateur 32 et à une borne de sortie 33 du filtre 30. Une autre borne du condensateur 32 est reliée à la masse.

Le circuit de régulation basse tension 34 comprend une borne d'entrée connectée à la borne de sortie 33 du filtre 30 et une borne de sortie 35 connectée au circuit de modulation et de démodulation 36, au circuit de logique 38 et à la mémoire 40. Le circuit de modulation et de démodulation 36 comporte une borne d'entrée connectée au point commun 23 et une borne de sortie connectée au circuit de logique 38 et à la mémoire 40. Le circuit de régulation basse tension 34 ainsi que le circuit de modulation et de démodulation 36 sont réalisés à partir de transistors, de résistances et de condensateurs selon des schémas connus.

Dans les cartes à puce sans contact, les données ainsi que l'énergie reçue par la puce sont transmises par le lecteur sous la forme d'un signal radiofréquence modulé en amplitude. Le signal reçu par la carte est détecté puis redressé à l'aide des circuits de détection 10 et de redressement 20 pour fournir une tension redressée $HV_1$ au point commun 23, dont l'amplitude moyenne varie en fonction de la puissance moyenne reçue par la carte, qui dépend principalement de la distance entre la carte et le lecteur. Lorsque la carte est proche du lecteur, de l'ordre de quelques centimètres, l'amplitude de la tension redressée $HV_1$ peut ainsi atteindre 15 à 20 V, avec un circuit de détection adéquat.

Le filtre 30 abaisse le niveau de la tension redressée $HV_1$ puis le circuit de régulation 34 permet d'obtenir, sur la borne de sortie 35, une basse tension d'alimentation $V_{cc}$ stable et continue, de l'ordre de 4 à 5 V. L'ensemble constitué des circuits de détection 10 et de redressement 20, du filtre 30 et du circuit de régulation basse tension 34 est ainsi équivalent à une source de tension stable qui fournit une basse tension d'alimentation $V_{cc}$.

Cette source de tension stable alimente tous les circuits de la carte à puce et en particulier le circuit de modulation et de démodulation 36, le circuit de logique 38 et la mémoire 40.

En parallèle, le circuit de modulation et de démodulation 36 décode la tension $HV_1$ et fournit un signal binaire DATA, contenant les données transmises à la carte, au circuit de logique 38 et à la mémoire 40.

La mémoire 40 est une mémoire programmable et effaçable électriquement, par exemple de type EEPROM ; elle comprend un plan mémoire 42 dans lequel sont mémorisées les données reçues par la carte et un circuit de logique 44 pour commander des opérations de lecture et / ou d'écriture dans le plan mémoire 42.

Pour réaliser une opération d'écriture dans le plan mémoire 42, il est nécessaire de disposer d'une tension de l'ordre de 16 à 18 V. Pour cela, un circuit élévateur de tension 46 fournit une haute tension de programmation HT continue et stable, à partir de la basse tension d'alimentation $V_{cc}$.

Le circuit élévateur de tension 46 est par exemple de type pompe de charge, et est réalisé à partir de condensateurs, de transistors et/ou de diodes selon un schéma connu. Les circuits de type pompe de charge sont parfaitement connus, par exemple du document D2 (WO 98/06056).

La carte à puce reçoit une quantité d'énergie limitée. Aussi, le plus souvent, une opération d'écriture est effectuée seule, afin d'utiliser au mieux l'énergie reçue par la carte. Néanmoins, pour fournir la haute tension de programmation HT, la pompe de charge consomme un courant important et donc une quantité d'énergie importante qui entraîne une surcharge du circuit de régulation basse tension qui fournit la basse tension $V_{cc}$ ; ceci peut éventuellement conduire à une perte des données reçues par la carte, à une mémorisation erronée de ces données ou bien à une rupture de la communication entre le lecteur et la carte à puce.

De plus, une pompe de charge classique occupe une surface de silicium importante qui peut atteindre 20% de la surface de silicium utilisée pour la mémoire. En effet, les éléments qui la composent, condensateurs et transistors en particulier, sont volumineux car ils sont dimensionnés pour supporter des tensions et des puissances importantes.

Enfin, une pompe de charge est fragile, en particulier parce que les condensateurs qui la constituent supportent assez mal des tensions trop élevées.

Au vu des inconvénients qui la caractérisent, un but de l'invention est de supprimer la pompe de charge d'une mémoire pour carte à puce. Ceci est envisageable à condition de pouvoir disposer d'une autre source de haute tension puisque ceci est indispensable pour les opérations d'écriture de la mémoire. La haute tension doit être de préférence continue et stable.

Avec cet objectif en vue, l'invention a pour objet un circuit intégré comportant un circuit de détection 10 et un circuit de redressement 20 associés en série, pour fournir une tension redressée $HV_1$, et un circuit de régulation basse tension 34 qui reçoit la tension redressée et qui fournit une basse tension d'alimentation $V_{cc}$. Selon l'invention, le circuit intégré comporte également un circuit de production de tension qui reçoit la tension redressée et qui produit une haute tension différente de la basse tension.

Ainsi, avec l'invention, la haute tension n'est plus produite à partir de la basse tension d'alimentation mais directement à partir de la tension redressée, ce qui permet de supprimer la pompe de charge habituellement utilisée.

La solution proposée présente l'avantage de séparer le circuit de production de tension du circuit de régulation basse tension 34 qui fournit la basse tension d'alimentation $V_{cc}$ et des circuits qui lui sont connectés. On évite ainsi des éventuels dysfonctionnements de ces circuits dus à la surcharge du circuit de régulation basse tension. On évite également de perturber le transfert de données entre le lecteur et la carte puisque celui-ci est géré uniquement par le circuit de modulation et de démodulation 36 et le circuit de logique 38.

Par ailleurs, le circuit de production de tension de l'invention est beaucoup plus petit, moins fragile et consomme beaucoup moins d'énergie qu'une pompe de charge, comme on le verra mieux par la suite.

Enfin, en supprimant la pompe de charge habituellement utilisée dans les mémoires, l'invention permet d'économiser une surface de silicium non négligeable. Cet avantage est particulièrement intéressant pour des applications telles que les étiquettes électroniques, qui exigent des circuits plus petits.

Selon une application de l'invention, le circuit intégré comprend également une mémoire comportant un plan mémoire, le plan mémoire recevant la basse tension et la haute tension. Le plan mémoire est ainsi alimenté directement par le circuit de production de tension et non plus par une pompe de charge interne à la mémoire.

Selon un mode dé réalisation de l'invention, le circuit de production de tension est un simple fil. Ce mode de réalisation est particulièrement simple à mettre en oeuvre et il peut être suffisant dans le cas où le circuit intégré est utilisé toujours à la même distance du lecteur, à quelques centimètres. Dans ce cas en effet, l'amplitude de la tension redressée varie assez peu.

Selon un autre mode de réalisation, le circuit de production de tension comprend un interrupteur commandé qui est fermé lorsque qu'il reçoit un signal de commande (WRITE) actif, et ouvert sinon. Le signal de commande (WRITE) est par exemple un signal fourni par le circuit de logique 44 de la mémoire, s'il existe, ou bien par tout autre circuit de logique du circuit intégré. Ce mode de réalisation présente l'avantage d'appliquer la haute tension, égale à la tension redressée, seulement lorsqu'un signal de commande est fourni, c'est-à-dire uniquement lorsqu'elle est nécessaire. La consommation globale du circuit intégré est ainsi limitée.

Selon un autre mode de réalisation, le circuit de production de tension comprend l'interrupteur commandé qui reçoit la tension redressée, et fournit une tension intermédiaire qui est égale soit à la tension redressée s'il est fermé, soit à zéro s'il est ouvert, et un circuit de haute tension qui reçoit la tension intermédiaire, qui fournit la haute tension et qui ouvre ou ferme l'interrupteur pour réguler la haute tension. Ainsi, selon ce mode de réalisation, un circuit de régulation est placé en série après l'interrupteur. Aussi, le circuit de production de tension fournit en continu une haute tension régulée et constante.

Selon un autre mode de réalisation enfin, le circuit de production de tension comprend :

- l'interrupteur commandé qui reçoit la tension redressée, et fournit la tension intermédiaire,
- un circuit de haute tension qui reçoit la tension intermédiaire, et qui fournit la haute tension et un signal de régulation pour réguler la haute tension, et
- un circuit de commande qui reçoit le signal de régulation et le signal de commande, et qui fournit un signal de fermeture pour fermer ou ouvrir l'interrupteur commandé.

Selon ce dernier mode de réalisation, le circuit de production de tension fournit une haute tension continue et stable, particulièrement bien adaptée à la programmation d'une mémoire. De plus, le circuit ne consomme de l'énergie que lorsque qu'une haute tension est nécessaire, ce qui limite la consommation globale du circuit intégré.

De préférence, le circuit de commande comprend un comparateur à hystérésis pour comparer le signal de régulation (REGUL) à des premier et deuxième seuils et fournir le résultat de la comparaison sur une sortie du comparateur, et une porte logique comprenant une première entrée recevant le résultat de la comparaison et une deuxième entrée recevant le signal de commande, la porte logique fournissant le signal de fermeture.

De préférence encore, le signal de fermeture prend une première valeur logique, qui entraîne la fermeture de l'interrupteur commandé, lorsque le signal de commande est dans un premier état logique et lorsque la haute tension augmente et est inférieure à un seuil haut, et caractérisé en ce que le signal de fermeture prend une seconde valeur logique, qui entraîne l'ouverture de l'interrupteur, lorsque le signal de commande est dans le premier état logique et lorsque la haute tension diminue et est supérieure à un seuil bas, ou bien lorsque le signal de commande est dans un second état logique.

De préférence également, le circuit de haute tension comprend au moins un condensateur de filtrage pour filtrer la tension intermédiaire et un circuit de détection haute tension pour fournir le signal de régulation.

Pour séparer encore plus complètement le circuit de production d'une haute tension de programmation et le circuit de régulation basse tension qui fournit la basse tension d'alimentation $V_{cc}$ et augmenter en même temps la quantité d'énergie reçue par la carte à puce, une amélioration de l'invention consiste à ajouter des seconds circuits de détection et de redressement pour alimenter de façon séparée le circuit de production de la haute tension de programmation.

Enfin, l'invention a également pour objet une carte à puce caractérisée en ce qu'elle comprend un circuit intégré tel que celui décrit ci-dessus.

L'invention sera mieux comprise et d'autres particularités et avantages apparaîtront à la lecture de la description qui va suivre, la description faisant référence aux dessins annexés parmi lesquels :

- la figure 1 présente un schéma classique d'un circuit intégré pour carte à puce sans contact selon l'état de la technique,
- la figure 2 présente un schéma fonctionnel d'un circuit intégré selon l'invention,
- la figure 3 présente un mode de réalisation d'un circuit de production de tension selon l'invention,
- la figure 4 présente le détail d'un élément du circuit de production de tension, et
- les figures 5A et 5B sont des diagrammes des signaux à certains points du circuit de production tension selon l'invention.

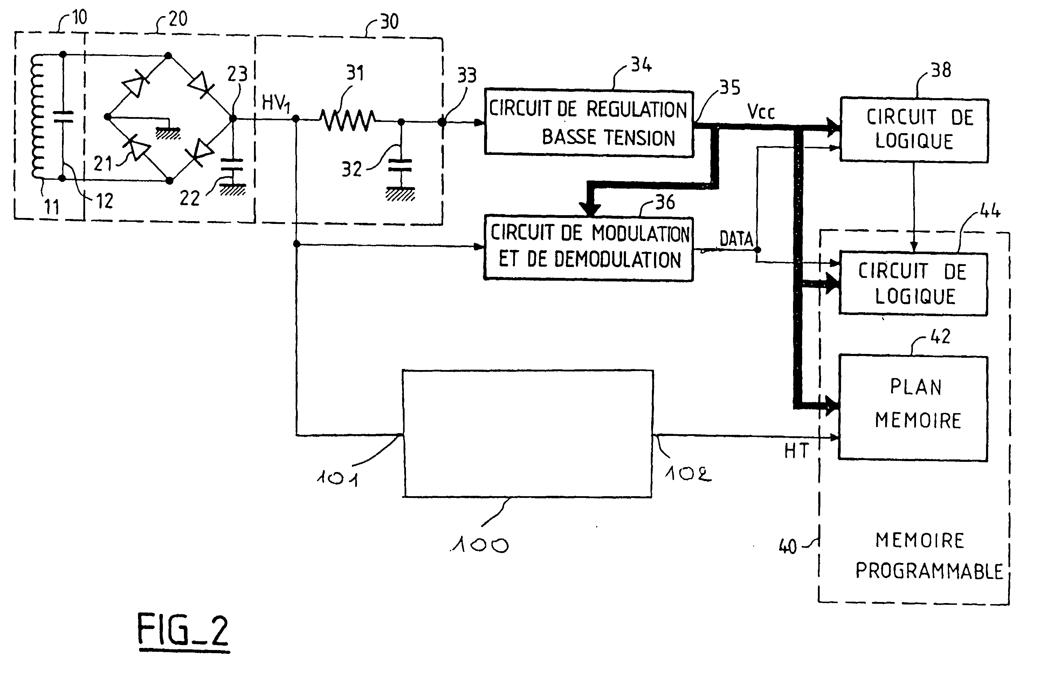

La figure 1 ayant été décrite précédemment et constituant l'état de la technique, elle ne sera pas décrite plus en détail. Les éléments de la figure 2 et ceux de la figure 1 ayant le même repère sont identiques.

La pompe de charge 46 de la figure 1 a été supprimée, conformément à la figure 2, et remplacée par un circuit de production de tension 100 selon l'invention. La tension redressée est appliquée sur une borne d'entrée 101 du circuit 100, qui fournit la haute tension HT sur une borne de sortie 102. La haute tension HT est ainsi fournie à partir de la tension redressée et non pas à partir de la basse tension d'alimentation comme précédemment.

Selon un mode de réalisation très simple (non représenté), le circuit de production de tension 100 est un simple fil, connecté entre le point commun 23 et le plan mémoire 42.

Selon un autre mode de réalisation (non représenté), le circuit de production de tension 100 comprend un interrupteur commandé par un signal de commande WRITE, fourni par exemple par le circuit de logique 42 de la mémoire 40 ou par le circuit de logique 38. Lorsque l'interrupteur 50 est fermé, la haute tension, égale à la tension redressée, est appliquée sur le plan mémoire.

Selon un autre mode de réalisation (non représenté), le circuit de production de tension comprend un interrupteur associé en série avec un circuit de haute tension qui régule la tension redressée en commandant l'ouverture ou la fermeture de l'interrupteur.

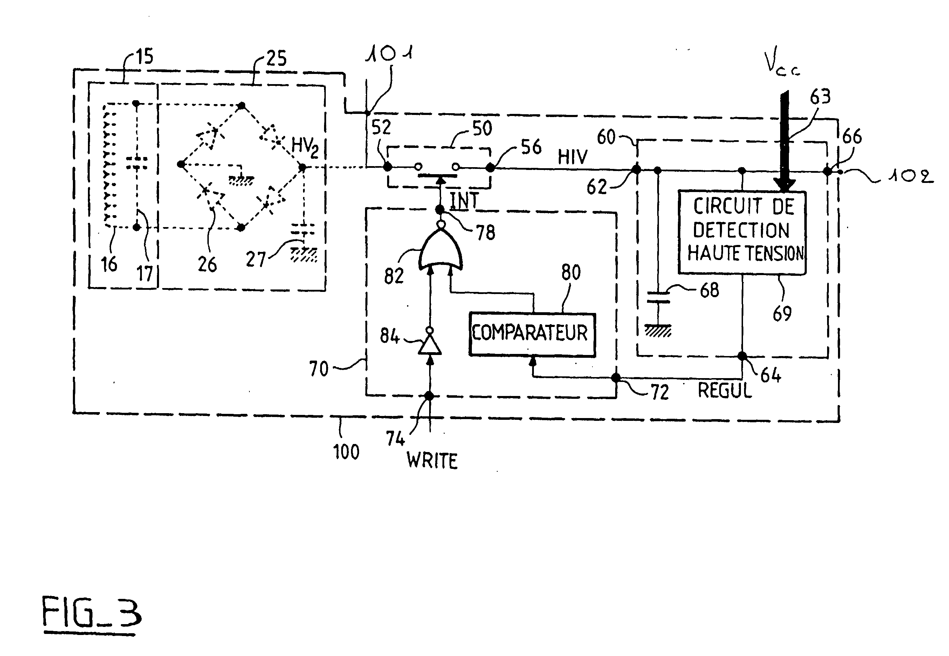

La figure 3 présente un mode de réalisation du circuit de production de tension 100 qui intègre les trois modes de réalisation ci-dessus, et qui présente tous les avantages cumulés de ces trois circuits.

Le circuit 100 de la figure 3 comprend un interrupteur commandé 50, un circuit de haute tension 60 et un circuit de commande 70. Eventuellement, mais non nécessairement, le circuit de production de tension 100 comporte également des seconds circuits de détection 15 et de redressement 25.

L'interrupteur commandé 50 comprend une borne d'entrée haute tension 52 connectée au point commun 23 pour recevoir la tension redressée $HV_1$ et une borne d'entrée de validation 54 ; Il fournit une tension intermédiaire HIV sur une borne de sortie haute tension 56. L'interrupteur commandé 50 est réalisé à partir de transistors selon un schéma connu.

Le circuit de haute tension 60 inclut un circuit de détection haute tension 69 et un condensateur de filtrage 68 dont une borne est reliée à la masse. Le circuit de haute tension 60 fournit une haute tension de programmation HT sur une borne de sortie haute tension 66.

Le circuit de haute tension 60 comprend une borne d'entrée haute tension 62, une borne d'entrée basse tension 63 sur laquelle est appliquée la basse tension d'alimentation $V_{cc}$ et une borne de sortie de commande 64 pour fournir un signal de régulation REGUL. La borne d'entrée haute tension 62 est connectée à la borne de sortie haute tension 56 de l'interrupteur commandé 50, à la borne de sortie haute tension 66 du circuit de haute tension 60 ainsi qu'à une autre borne du condensateur 68.

Le circuit de commande 70 comprend une première borne d'entrée de validation 72 connectée à la borne de sortie de commande 64 du circuit de haute tension 60 pour recevoir le signal de régulation REGUL, une deuxième borne d'entrée de validation 74 pour recevoir un signal de commande WRITE, et une borne de sortie de commande 78 reliée à la borne d'entrée de validation 54 de l'interrupteur commandé 50 pour fournir un signal de fermeture INT. Le signal WRITE est par exemple fourni par le circuit de logique de la mémoire 40.

Le circuit de commande 70 comprend un comparateur 80, une porte logique 82, par exemple de type NON-OU et un inverseur 84. Le comparateur 80 est par exemple un comparateur à hystérésis qui transforme un signal analogique reçu sur une borne d'entrée, en un signal digital fourni sur une borne de sortie. Par exemple, si le signal analogique reçu augmente, le comparateur fournit un "1" logique lorsque le signal analogique reçu atteint un premier seuil $V_1$. Inversement, si le signal analogique reçu diminue, le comparateur fournit un "0" logique lorsque le signal analogique reçu atteint un second seuil $V_2$, inférieur à $V_1$. Le comparateur 80 est réalisé à partir de transistors selon un schéma connu.

La porte logique 82 comprend deux bornes d'entrée connectées respectivement à la première borne d'entrée de validation 72 par l'intermédiaire du comparateur 80 et à la deuxième borne d'entrée de validation 74 par l'intermédiaire d'un inverseur 86. La porte logique 82 fournit le signal de fermeture INT sur une borne de sortie connectée à la borne de sortie de commande 78.

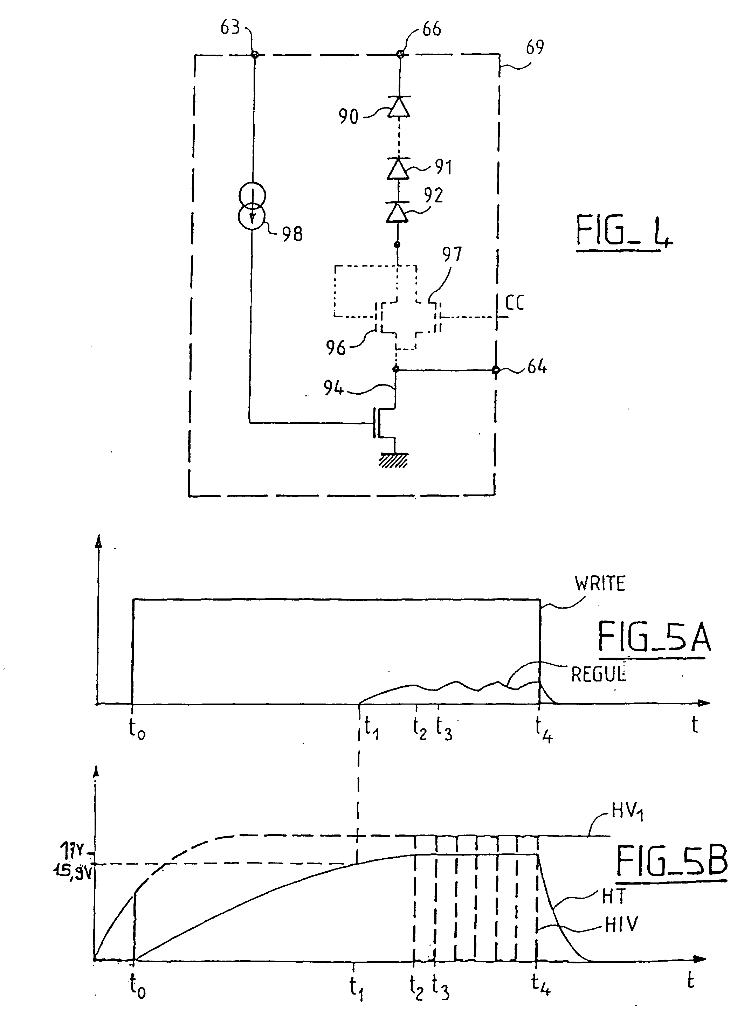

Le circuit de détection haute tension 69 comprend, conformément à la figure 4, n diodes 90 à 92, n étant un nombre par exemple égal à trois, un transistor 94 et une source de courant 98. Les n diodes 90 à 92 sont connectées en série, la cathode de la diode 90 étant connectée à la borne d'entrée haute tension 62 et l'anode de la diode 92 étant connectée à la borne de sortie de commande 64 et au drain du transistor 94, dont la source est reliée à la masse. Les n diodes 90 à 92 sont par exemple de type zener et ont par exemple une tension ce seuil $V_T$ égale à 5,3 V.

Une des bornes de la source de courant 98 est connectée à la borne d'entrée basse tension 63 et une autre borne est reliée à la grille du transistor 94. Le courant fourni par la source de courant 98 polarise le transistor 94 et a de préférence une valeur assez faible, par exemple 500 nA, afin de ne pas surcharger inutilement le circuit de production de tension 100.

Le signal de régulation REGUL, fourni par le circuit de détection haute tension 69 sur la borne de sortie de commande 64 est un signal analogique qui dépend du nombre n de diodes 90 à 92, de la tension de seuil $V_T$ de ces diodes et de la valeur de la haute tension HT sur la borne de sortie haute tension 66; le signal de régulation REGUL est ainsi égal à :

$$REGUL = HT - n*V_T \qquad si \; HT - n*V_T \geq 0$$

$$REGUL = 0 \qquad si \; HT - n*V_T < 0$$

De même, la valeur maximale $V_{HT1}$ de la haute tension HT sur la borne de sortie 66 dépend du nombre n de diodes 90 à 92, de la tension de seuil $V_T$ de ces diodes et de la valeur du premier seuil $V_1$ du comparateur 80. Par exemple, en prenant un nombre de diodes n égal à trois, en choisissant des diodes de type Zener ayant une tension de seuil $V_T$ égale à 5,3 V, et en choisissant une valeur du premier seuil $V_1$ égale à 1,1 V, la valeur maximale $V_{HT1}$ (ou valeur de seuil haut), de la haute tension HT sera égale à $V_{HT1} = n*V_T + V_1$, soit $V_{HT1} = 17$ V.

Le circuit de détection haute tension 69 peut être amélioré en insérant, entre la diode 92 et le transistor 94, deux transistors 96 et 97 (optionnels) représentés en pointillés sur la figure 4. Les drains des transistors 96 et 97 sont connectés ensemble à l'anode de la diode 92 et leurs sources sont connectées ensemble au drain du transistor 94. La grille et le drain du transistor 96 sont reliés ensemble pour former une diode et la grille du transistor 97 reçoit un signal de commande CC du circuit de logique 44 (la connexion entre le transistor 97 et le circuit de logique 44 n'est pas représentée sur les figures 2 et 3). Lorsque le signal de commande CC est égal à "1", le transistor 97 est passant et le transistor 96 est équivalent à un court circuit. Inversement, lorsque le signal de commande CC est égal à "0", le transistor 97 est bloqué et le transistor est équivalent à une diode, ayant une tension de seuil $V_T$' égale à environ 1 V. Si, au cours de l'utilisation du circuit de production de tension 100, il s'avère nécessaire de disposer d'une haute tension HT supérieure à la valeur initialement prévue, par exemple de 18 V, il suffira d'appliquer un signal de commande CC égal à "0" sur la grille du transistor 97. Dans ce cas, la valeur maximale $V_{HT1}$ de la haute tension de programmation obtenue sera égale à $V_{HT1} = n*V_T + V_T' + V_1$.

Cette option est intéressante dans la mesure où, le plus souvent, au cours du temps, les tensions de seuil des transistors à grille flottante constituant les cellules du plan mémoire 42 peuvent se décaler et nécessiter l'utilisation d'une haute tension de programmation HT plus élevée que celle initialement prévue.

Cette option est également intéressante pour effectuer des procédures de test de la qualité des circuits intégrés lors de leur production.

Le circuit de production de tension 100 peut également être amélioré en ajoutant des seconds circuits de détection 15 et de redressement 25, représentés en pointillés sur la figure 3 et identiques aux circuits 10 et 20, pour fournir une deuxième tension redressée $HV_2$. Dans ce cas, la sortie du second circuit de redressement 25 doit être connectée à l'entrée haute tension 52 de l'interrupteur commandé 50 et la liaison entre le point commun 23 et l'entrée haute tension 52 doit être supprimée.

Le circuit de production de tension 100 peut ainsi être envisagé de deux manières différentes :

Dans une première version, le circuit 100 reçoit une tension redressée $HV_1$ fournie par des circuits de détection 10 et de redressement 20 extérieurs ; il fournit dans ce cas une haute tension HT à partir de la tension redressée $HV_1$.

Dans une seconde version, le circuit 100 comprend des seconds circuits de détection 15 et de redressement 25 qui fournissent une tension redressée $HV_2$ ; le circuit de production de tension 100 fournit dans ce cas la haute tension HT à partir de la tension redressée

HV$_2$. Il peut ainsi fonctionner de façon autonome, indépendamment des autres circuits de la carte à puce, et en particulier du circuit de régulation basse tension 34 et du circuit de modulation et de démodulation 36.

La seconde version présente l'avantage de séparer complètement le circuit de production de tension 100 et le circuit de régulation basse tension 34 fournissant la basse tension d'alimentation V$_{cc}$ aux circuits qui lui sont connectés. De plus, la carte à puce reçoit ainsi environ deux fois plus d'énergie, ce qui permet d'effectuer plusieurs opérations en même temps, par exemple un échange de données entre la carte à puce et le lecteur, même lorsqu'une opération d'écriture de la mémoire est en cours de réalisation.

Préférentiellement, les composants des circuits de puissance devant supporter des hautes tensions, en particulier les circuits de détection 10, 15, les circuits de redressement 20, 25, l'interrupteur commandé 50, et le circuit de haute tension 60, sont des composants de puissance afin de supporter les hautes tensions, par exemple HV$_1$, HV$_2$, HIV et HT, et les puissances correspondantes.

Le fonctionnement du circuit de production de tension 100 de la figure 3 va maintenant être décrit en relation avec les figures 5A et 5B. Afin de faciliter la compréhension de ces deux figures, l'échelle n'a pas été respectée pour les différents signaux.

Dans l'exemple qui suit, nullement limitatif de l'invention, on suppose que la carte à puce reçoit un signal radiofréquence à l'instant t = 0 ; on suppose également que les diodes 90 à 92 sont au nombre de trois et ont une tension de seuil V$_T$ égale à 5,3 V, et que les premier et deuxième seuils V$_1$ et V$_2$ du comparateur 80 ont pour valeurs respectives 1,1 et 1 V, de façon à obtenir une valeur maximale U$_{HT1}$ de la haute tension HT égale à 17 V.

Initialement, pendant un temps t compris entre 0 et t$_0$, aucune opération d'écriture n'est en cours, le signal de commande WRITE (figure 5A) ainsi que le signal de fermeture INT (non représenté) ont une valeur logique "0" et l'interrupteur commandé 50 est ouvert. Dans ce cas, la tension intermédiaire HIV ainsi que la haute tension HT (figure 5B) sont nulles. La tension redressée HV$_1$ (ou HV$_2$), aux bornes du circuit de redressement 20 (ou 25), augmente rapidement.

Lorsqu'une opération d'écriture est déclenchée, à l'instant t = t$_0$, Le signal de commande d'écriture WRITE prend la valeur logique "1", de même que le signal de commande INT. L'interrupteur commandé 50 se ferme, la tension intermédiaire HIV est égale à la tension redressée HV$_1$ (ou HV$_2$) et la haute tension HT augmente lentement du fait de la présence du condensateur de filtrage 68. Le signal de régulation REGUL est nul et le comparateur 80 fournit un "0" logique.

Lorsque la haute tension HT atteint la valeur n*V$_T$ (c'est-à-dire 15,9 V dans notre exemple) à l'instant t$_1$, le signal de régulation REGUL, initialement nul, prend la valeur REGUL = HT - n*V$_T$ et augmente avec la haute tension HT, jusqu'à atteindre le premier seuil V$_1$ du comparateur 80 à l'instant t$_2$.

A l'instant t$_2$, le comparateur 80 fournit un "1" logique, le signal de fermeture INT prend alors la valeur logique "0", ce qui a pour conséquence l'ouverture de l'interrupteur commandé 50. La tension intermédiaire HIV prend dans ce cas une valeur nulle. La haute tension HT, quant à elle, ne chute pas brutalement du fait de la présence du condensateur de filtrage 68, mais décroît légèrement. Le signal de régulation REGUL décroît également jusqu'à atteindre le deuxième seuil V$_2$ du comparateur 80 à l'instant t$_3$ (la haute tension HT vaut alors V$_{HT2}$ = n*V$_T$ + V$_2$ = 16,9 V, ce qui correspond à un seuil bas).

A l'instant t$_3$, Le comparateur 80 fournit un "0" logique qui entraîne le passage à "1" du signal INT et la fermeture de l'interrupteur commandé 50. La tension intermédiaire HIV prend la valeur de la tension redressée HV$_1$ (ou HV$_2$) et la haute tension HT augmente à nouveau légèrement.

La haute tension HT va ainsi varier légèrement entre un seuil bas V$_{HT2}$ = 16,9 V et un seuil haut V$_{HT1}$ = 17 V; la haute tension HT obtenue est ainsi particulièrement stable.

A l'instant t$_4$, l'opération d'écriture du plan mémoire se termine, la haute tension HT n'est dans ce cas plus nécessaire. Le signal de commande d'écriture WRITE prend la valeur logique "0", de même que le signal de commande INT, ce qui entraîne l'ouverture de l'interrupteur commandé 50. La tension intermédiaire HIV est dans ce cas nulle et la haute tension HT décroît lentement jusqu'à zéro, de même que le signal de régulation REGUL, à cause de l'énergie emmagasinée dans le condensateur de filtrage 68. Le circuit de production de tension 100 est ainsi revenu dans son état initial.

## Nomenclature

| | |
|---|---|
| 10 | circuit de détection |
| 11 | bobinage |
| 12 | condensateur |
| 15 | circuit de détection |
| 16 | bobinage |
| 17 | condensateur |
| 20 | circuit de redressement |
| 21 | pont à quatre diodes |
| 22 | condensateur |
| 23 | point commun du pont 21 et du condensateur 22 |
| 25 | circuit de redressement |
| 26 | pont à quatre diodes |
| 27 | condensateur |
| 30 | filtre |
| 31 | résistance |
| 32 | condensateur |
| 33 | borne de sortie du filtre |

| 34 | circuit de régulation basse tension |
| 35 | borne de sortie du circuit 34 |
| 36 | circuit de modulation et de démodulation |
| 38 | circuit de logique |
| 40 | mémoire |
| 42 | plan mémoire |
| 44 | circuit de logique |
| 46 | circuit élévateur de tension |
| 50 | interrupteur commandé |
| 52 | entrée haute tension de l'interrupteur 50 |
| 54 | entrée de validation de l'interrupteur 50 |
| 56 | sortie haute tension de l'interrupteur 50 |
| 60 | circuit de haute tension |
| 62 | entrée haute tension du circuit 60 |
| 63 | entrée basse tension du circuit 60 |
| 64 | sortie de commande du circuit 60 |
| 66 | sortie haute tension du circuit 60 |
| 68 | condensateur de filtrage |
| 69 | circuit de détection haute tension |
| 70 | circuit de commande |
| 72 | première entrée de validation du circuit 70 |
| 74 | deuxième entrée de validation du circuit 70 |
| 78 | sortie de commande du circuit 70 |
| 80 | comparateur |
| 82 | porte logique |
| 84 | inverseur |
| 90 à 92 | n diodes |
| 94 | transistor |
| 96 | transistor |
| 97 | transistor |
| 98 | source de courant |
| 100 | circuit de production de tension |
| 101 | borne d'entrée du circuit 100 |
| 102 | borne de sortie du circuit 100 |

**Revendications**

1.  Circuit intégré comportant :

    -   un circuit de détection (10) et un circuit de redressement (20) associés en série, pour fournir une tension redressée ($HV_1$) à partir d'un signal radio fréquence reçu par le circuit de détection (10), et
    -   un circuit de régulation basse tension (30, 34) qui reçoit la tension redressée ($HV_1$) et qui fournit une basse tension (Vcc),

    le circuit étant **caractérisé en ce qu'**il comporte également :

    -   un circuit de production de tension (100) différent d'une pompe de charge, qui reçoit la tension redressée ($HV_1$) et qui produit une haute tension ($H_T$) différente de la basse tension (Vcc), et
    -   une mémoire (40) qui reçoit la haute tension (HT).

2.  Circuit selon la revendication 1, **caractérisé en ce que** la mémoire (40) comprend un plan mémoire (42) recevant la basse tension (vcc) et la haute tension (HT).

3.  Circuit selon la revendication 1, **caractérisé en ce que** le circuit de production de tension est un fil connecté entre une borne de sortie du circuit de redressement (20) et une borne d'entrée de la mémoire.

4.  Circuit selon la revendication 1, **caractérisé en ce que** le circuit de production de tension (100) comprend un interrupteur commandé (50) qui est fermé lorsque qu'il reçoit un signal de commande (WRITE) actif ("1"), et ouvert sinon.

5.  Circuit selon la revendication 1, **caractérisé en ce que** le circuit de production de tension (100) comprend :

    -   l'interrupteur commandé (50) qui reçoit la tension redressée ($HV_1$, $HV_2$), et fournit une tension intermédiaire (HIV) qui est égale soit à la tension redressée ($HV_1$, $HV_2$) s'il est fermé, soit à zéro s'il est ouvert,
    -   un circuit de haute tension (60, 80) qui reçoit la tension intermédiaire (HIV), et qui fournit la haute tension (HT) et qui ouvre ou ferme l'interrupteur (50) pour réguler la haute tension (HT).

6.  Circuit selon la revendication 1, **caractérisé en ce que** le circuit de production de tension (100) comprend :

    -   l'interrupteur commandé (50) qui reçoit la tension redressée ($HV_1$, $HV_2$), et fournit la tension intermédiaire (HIV),
    -   un circuit de haute tension (60) qui reçoit la tension intermédiaire (HIV), et qui fournit la haute tension (HT) et un signal de régulation (REGUL) pour réguler la haute tension (HT), et
    -   un circuit de commande (70) qui reçoit le signal de régulation (REGUL) et le signal de commande (WRITE), et qui fournit un signal de fermeture (INT) pour fermer ou ouvrir l'interrupteur commandé (50).

7.  Circuit selon la revendication 6, **caractérisé en ce que** le circuit de commande (70) comprend :

    -   un comparateur à hystérésis (80) pour comparer le signal de régulation (REGUL) à des premier ($V_1$) et deuxième seuils ($V_2$) et fournir le résultat de la comparaison sur une sortie du comparateur (80),

- une porte logique (82) comprenant une première entrée recevant le résultat de la comparaison et une deuxième entrée (74) recevant le signal de commande (WRITE), la porte logique (82) fournissant le signal de fermeture (INT).

8. Circuit selon l'une des revendications 6 ou 7, **caractérisé en ce que** le signal de fermeture (INT) prend une première valeur logique ("1"), qui entraîne la fermeture de l'interrupteur commandé (50), lorsque le signal de commande (WRITE) est dans un premier état logique ("1") et lorsque la haute tension (HT) augmente et est inférieure à un seuil haut ($V_{HT1}$), et **caractérisé en ce que** le signal de fermeture (INT) prend une seconde valeur logique ("0"), qui entraîne l'ouverture de l'interrupteur (50), lorsque le signal de commande (WRITE) est dans le premier état logique ("1") et lorsque la haute tension (HT) diminue et est supérieure à un seuil bas ($V_{HT2}$), ou bien lorsque le signal de commande (WRITE) est dans un second état logique ("0").

9. Circuit selon l'une des revendications 5 ou 6, dans lequel le circuit de haute tension (60) comprend au moins un condensateur de filtrage (68) pour filtrer la tension intermédiaire (HIV) et un circuit de détection haute tension (69) pour fournir le signal de régulation (REGUL).

10. Circuit selon la revendication 9, dans lequel le circuit de détection haute tension (69) comporte :

   - n diodes (90 à 92) identiques connectées en série, une cathode de la première diode (90) étant connectée à une borne d'entrée haute tension (62) du circuit de haute tension (60) et une anode de la $n^{ième}$ diode (92) étant connectée à une borne de sortie de commande (64) du circuit de haute tension (60),
   - un transistor (94) dont un drain est connecté à la borne de sortie de commande (64) et dont une source est reliée à la masse,
   - une source de courant (98) dont une borne est connectée à une grille du transistor (94) pour le rendre passant.

11. Circuit selon la revendication 10, dans lequel le circuit de détection haute tension (69) comporte en outre deux transistors (96, 97), les drains des deux transistors (96, 97) étant connectés ensemble à l'anode de la $n^{ième}$ diode (92), les sources des deux transistors (96, 97) étant connectées ensemble au drain du transistor (94), la grille du transistor (96) étant connectée à son drain pour former une diode et la grille du transistor (97) recevant un signal de commande (CC).

12. Circuit selon la revendication 1, **caractérisé en ce**

**qu'**il comporte également un deuxième circuit de détection (15) et un deuxième circuit de redressement (25) pour fournir une deuxième tension redressée ($HV_2$), le circuit de production de tension (110) produisant la haute tension (HT) à partir de la deuxième tension régulée ($HV_2$).

13. Carte à puce **caractérisée en ce qu'**elle comprend un circuit intégré selon l'une des revendications 1 à 12.


**Patentansprüche**

1. Integrierte Schaltung, die aufweist:

   - eine Erfassungsschaltung (10) und Gleichrichterschaltung (20) in Reihe geschaltet, um ausgehend von einem von der Erfassungsschaltung (10) empfangenen Radiofrequenz-Signal eine gleichgerichtete Spannung ($HV_1$) zu liefern, und
   - eine Niederspannungs-Regelungsschaltung (30, 34), die die gleichgerichtete Spannung ($HV_1$) empfängt und eine Niederspannung (Vcc) liefert,

   wobei die Schaltung **dadurch gekennzeichnet** wird, dass sie auch aufweist:

   - eine sich von einer Ladungspumpe unterscheidende Spannungserzeugerschaltung (100), die die gleichgerichtete Spannung ($HV_1$) empfängt und eine sich von der Niederspannung (Vcc) unterscheidende Hochspannung (HT) erzeugt, und
   - einen Speicher (40), der die Hochspannung (HT) empfängt.

2. Schaltung nach Anspruch 1, **dadurch gekennzeichnet, dass** der Speicher (40) einen Speicherplan (42) aufweist, der die Niederspannung (Vcc) und die Hochspannung (HT) empfängt.

3. Schaltung nach Anspruch 1, **dadurch gekennzeichnet, dass** die Spannungserzeugerschaltung ein Draht ist, der zwischen einem Ausgangsanschluss der Gleichrichterschaltung (20) und einem Eingangsanschluss des Speichers angeschlossen ist.

4. Schaltung nach Anspruch 1, **dadurch gekennzeichnet, dass** die Spannungserzeugerschaltung (100) einen Steuer-Unterbrecher (50) aufweist, der geschlossen ist, wenn er ein Steuersignal (WRITE) aktiv ("1") empfängt und sonst geöffnet ist.

5. Schaltung nach Anspruch 1, **dadurch gekenn-**

**zeichnet, dass** die Spannungserzeugerschaltung (100) aufweist:

- den Steuer-Unterbrecher (50), der die gleichgerichtete Spannung ($HV_1$, $HV_2$) empfängt und eine Zwischenspannung (HIV) liefert, die entweder der gleichgerichteten Spannung ($HV_1$, $HV_2$) entspricht, wenn er geschlossen ist oder gleich Null ist, wenn er geöffnet ist,
- eine Hochspannungsschaltung (60, 80), die die Zwischenspannung (HIV) empfängt und die Hochspannung (HT) liefert, und die den Unterbrecher (50) öffnet oder schließt, um die Hochspannung (HT) zu regeln.

6. Schaltung nach Anspruch 1, **dadurch gekennzeichnet, dass** die Spannungserzeugerschaltung (100) folgendes aufweist:

- den Steuer-Unterbrecher (50), der die gleichgerichtete Spannung ($HV_1$, $HV_2$) empfängt und die Zwischenspannung (HIV) liefert,
- eine Hochspannungsschaltung (60), die die Zwischenspannung (HIV) empfängt und die Hochspannung (HT) und ein Regelungssignal (REGUL) liefert, um die Hochspannung (HT) zu regeln, und
- eine Steuerschaltung (70), die das Regelungssignal (REGUL) und das Steuersignal (WRITE) empfängt und die ein Schließsignal (INT) liefert, um den Steuer-Unterbrecher (50) zu schließen und zu öffnen.

7. Schaltung nach Anspruch 6, **dadurch gekennzeichnet, dass** die Steuerschaltung (70) folgendes aufweist:

- einen Komparator (80) mit Hysterese, um das Regelungssignal (REGUL) mit einem ersten Schwellenwert ($V_1$) und einem zweiten Schwellenwert ($V_2$) zu vergleichen und das Ergebnis dieses Vergleichs an einen Ausgang des Komparators (80) zu liefern.
- ein Logikgatter (82), das einen ersten Eingang, der das Vergleichsergebnis empfängt und einen zweiten Eingang (74) aufweist, der das Steuersignal (WRITE) empfängt, wobei das Logikgatter (82) das Schließsignal (INT) liefert.

8. Schaltung nach einem der Ansprüche 6 oder 7, **dadurch gekennzeichnet, dass** das Schließsignal (INT) einen ersten logischen Wert (" 1 ") nimmt, der das Schließen des Steuer-Unterbrechers (50) verursacht, wenn das Steuersignal (WRITE) in einem ersten logischen Zustand ("1") ist und wenn die Hochspannung (HT) ansteigt und niedriger als ein hoher Schwellenwert ($V_{HT1}$) ist, und **dadurch gekennzeichnet, dass** das Schließsignal (INT) einen zweiten logischen Wert ("0") nimmt, der das Öffnen des Unterbrechers (50) verursacht, wenn das Steuersignal (WRITE) in einem ersten logischen Zustand (" 1 ") ist und wenn die Hochspannung (HT) sinkt und höher als ein niedriger Schwellenwert ($V_{HT2}$) ist, oder wenn das Steuersignal (WRITE) in einem zweiten logischen Zustand ("0") ist.

9. Schaltung nach einem der Ansprüche 5 oder 6, in der die Hochspannungsschaltung (60) mindestens einen Filterkondensator (68), um die Zwischenspannung (HIV) zu filtern und eine Hochspannungs-Erfassungsschaltung (69) aufweist, um das Regelungssignal (REGUL) zu liefern.

10. Schaltung nach Anspruch 9, in der die Hochspannungs-Erfassungsschaltung (69) folgendes aufweist:

- n identische, in Reihe geschaltete Dioden (90 bis 92), eine Kathode der ersten Diode (90), die an einen Hochspannungs-Eingangsanschluss (62) der Hochspannungsschaltung (60) angeschlossen ist und eine Anode der $n^{ten}$ Diode (92), die an einen Steuer-Ausgangsanschluss (64) der Hochspannungsschaltung (60) angeschlossen ist,
- einen Transistor (94), dessen Senke an den Steuer-Ausgangsanschluss (64) angeschlossen ist und dessen Source mit der Masse verbunden ist,
- eine Stromquelle (98), deren einer Anschluss mit dem Gitter des Transistors (94) verbunden ist, um ihn durchgängig zu machen.

11. Schaltung nach Anspruch 10, in der die Hochspannungs-Erfassungsschaltung (69) außerdem zwei Transistoren (96, 97) aufweist, wobei die Senken der beiden Transistoren (96, 97) zusammen an die Anode der $n^{ten}$ Diode (92) angeschlossen sind, die Sourcen der beiden Transistoren (96, 97) zusammen an die Senke des Transistors (94) angeschlossen sind, das Gitter des Transistors (96) an seine Senke angeschlossen ist, um eine Diode zu bilden und das Gitter des Transistors (97) ein Steuersignal (CC) empfängt.

12. Schaltung nach Anspruch 1, **dadurch gekennzeichnet, dass** sie auch eine zweite Erfassungsschaltung (15) und eine zweite Gleichrichterschaltung (25) aufweist, um eine zweite gleichgerichtete Spannung ($HV_2$) zu liefern, wobei die Spannungserzeugerschaltung (110) die Hochspannung (HT) ausgehend von der zweiten geregelten Spannung ($HV_2$) erzeugt.

13. Chipkarte **dadurch gekennzeichnet, dass** sie eine integrierte Schaltung nach einem der Ansprüche 1 bis 12 aufweist.

**Claims**

1. An integrated circuit comprising:

   - a detection circuit (10) and a rectifier circuit (20) associated in series, for supplying a rectified voltage ($HV_1$) derived from a radio frequency signal received by the detection circuit (10), and

   - a low tension regulating circuit (30, 34) which receives the rectified voltage ($HV_1$) and which supplies a low voltage (Vcc),

   the circuit being **characterised in that** it further includes:

   - a voltage producing circuit (100) which is different from a charge pump, and which receives the rectified voltage ($HV_1$) and produces a high voltage (HT) different from the low voltage (Vcc), and

   - a memory (40) which receives the high voltage (HT).

2. A circuit according to Claim 1, **characterised in that** the memory (40) includes a memory circuit (42) for receiving the low voltage (Vcc) and the high voltage (HT).

3. A circuit according to Claim 1, **characterised in that** the voltage producing circuit is a wire connected between an output terminal of the rectifier circuit (20) and an input terminal of the memory.

4. A circuit according to Claim 1, **characterised in that** the voltage producing circuit (100) includes a controlled interrupter (50) which is closed while it is receiving a control signal (WRITE) which is active ("1"), and is open when not so receiving.

5. A circuit according to Claim 1, **characterised in that** the voltage producing circuit (100) comprises:

   - the controlled interrupter (50) which receives the rectified voltage ($HV_1$, $HV_2$), and supplies an intermediate voltage (HIV) which is equal either to the rectified voltage ($HV_1$, $HV_2$) if it is closed, or to zero if it is open,

   - a high tension circuit (60, 80) which receives the intermediate voltage (HIV) and which supplies the high voltage (HT), and which opens or closes the interrupter (50) whereby to regulate the high voltage (HT).

6. A circuit according to Claim 1, **characterised in that** the voltage producing circuit (100) comprises:

   - the controlled interrupter (50) which receives the rectified voltage ($HV_1$, $HV_2$) and supplies the intermediate voltage (HIV),

   - a high tension circuit (60), which receives the intermediate voltage (HIV) and supplies the high voltage (HT) and a regulating signal (REGUL), whereby to regulate the high voltage (HT), and

   - a control circuit (70) which receives the regulating signal (REGUL) and the control signal (WRITE), and which supplies a closing signal (INT) for closing or opening the controlled interrupter (50).

7. A circuit according to Claim 6, **characterised in that** the control circuit (70) comprises:

   - a hysteresis comparator (80) for comparing the regulating signal (REGUL) with a first threshold ($V_1$) and a second threshold ($V_2$), and for comparing the result of the comparison on an output of the comparator (80),

   - a logic gate (82) having a first input receiving the result of the comparison and a second input (74) for receiving the control signal (WRITE), the logic gate (82) supplying the closing signal (INT).

8. A circuit according to Claim 6 or Claim 7, **characterised in that** the closing signal (INT) takes a first logic value ("1") which triggers closing of the controlled interrupter (50), when the control signal (WRITE) is in a first logic state ("1") and when the high voltage (HT) is increasing and is below an upper threshold value ($V_{HT1}$), and **characterised in that** the closing signal (INT) takes a second logic value ("0"), which triggers opening of the interrupter (50), when the control signal (WRITE) is in the first logic state ("1") and when the high voltage (HT) is diminishing and is above a lower threshold value ($V_{HT2}$), or alternatively when the control signal (WRITE) is in a second logic state ("0").

9. A circuit according to Claim 5 or Claim 6, in which the high tension circuit (60) comprises at least one filter condenser (68) for filtering the intermediate voltage (HIV) and a high voltage detection circuit (69) for supplying the regulating signal (REGUL).

10. A circuit according to Claim 9, wherein the high voltage detection circuit (69) comprises:

- n diodes (90 - 92) identical with each other and connected in series, a cathode of the first diode (90) being connected to a high voltage input terminal (62) of the high tension circuit (60), and an anode of the nth diode (92) being connected to a control output terminal (64) of the high tension circuit (60),

- a transistor (94), a drain of which is connected to the control output terminal (64), a source of the transistor being earthed,

- a current source (98), a terminal of which is connected to a grid of the transistor (94) to render it passing.

11. A circuit according to Claim 10, wherein the high voltage detection circuit (69) further includes two transistors (96, 97), the drains of the two transistors (96, 97) being connected together to the anode of the nth diode (92), the sources of the two transistors (96, 97) being connected together to the drain of the transistor (94), the grid of the transistor (96) being connected to its drain whereby to constitute a diode, and the grid of the transistor (97) receiving a control signal (CC).

12. A circuit according to Claim 1, **characterised in that** it further includes a second detection circuit (15) and a second rectifying circuit (25), for supplying a second rectified voltage ($HV_2$), the voltage producing circuit (110) producing the high voltage (HT) from the regulated second voltage ($HV_2$).

13. A microchip, **characterised in that** it comprises an integrated circuit according to one of Claims 1 to 12.

FIG_1

ART ANTERIEUR

EP 1 196 926 B1

EP 1 196 926 B1

FIG_2

FIG_3

63    66                    69

90

91
        92

98                    97

                        CC

96

                        64
94

FIG_4

WRITE

FIG_5A

REGUL

$t_0$          $t_1$   $t_2$ $t_3$   $t_4$    t

HV$_1$

11V
15,9V                                    FIG_5B

HT
HIV

$t_0$          $t_1$   $t_2$ $t_3$   $t_4$    t

15